Europäisches Patentamt

European Patent Office

Office européen des brevets

(19)

(11) **EP 0 487 808 B1**

(12) **EUROPEAN PATENT SPECIFICATION**

(45) Date of publication and mention
of the grant of the patent:
**19.02.1997   Bulletin 1997/08**

(51) Int Cl.⁶: **G11C 16/06**

(21) Application number: **90830529.5**

(22) Date of filing: **19.11.1990**

(54) **Memories with unbalanced loads and with compensation**

Speichern mit ungleichen Lasten und mit Kompensation

Mémoires avec des charges inégales et avec compensation

(84) Designated Contracting States:
**DE FR GB IT NL SE**

(43) Date of publication of application:
**03.06.1992   Bulletin 1992/23**

(73) Proprietor: **SGS-THOMSON
MICROELECTRONICS S.r.l.
20041 Agrate Brianza (Milano) (IT)**

(72) Inventors:
• **Pascucci, Luigi
  I-20099 Sesto San Giovanni, Milano (IT)**
• **Olivo, Marco
  I-24100 Bergamo (IT)**

(74) Representative: **Forattini, Amelia et al
c/o Internazionale Brevetti
Ingg. ZINI, MARANESI & C. S.r.l.
Piazza Castello 1
20121 Milano (IT)**

(56) References cited:
**EP-A- 0 347 935**

## Description

This invention is concerned with a memory having an improved sense circuit, of the type with unbalanced loads, for recognizing the virgin or programmed status of the cells in storage devices such as CMOS non-volatile memories.

In circuits made with CMOS technology, where programmable components are used to make non-volatile memories (ROM, EPROM, EEPROM, FLASH), it is necessary to provide a reference system which is able to recognize programmed elements (which are turned off) from non-programmed, or virgin, elements (which are turned on). Recognition is achieved by comparing the current $I_v$ in a virgin reference cell with the current in the matrix element or cell which it is desired to read. The latter current will ideally be zero for a programmed cell ($I_p$), non-zero for a virgin cell ($I_v$). In order to have a balanced comparison where the discrimination value lies at the middle between $I_v$ and $I_p$, it is known to shift the threshold by using differently sized loads for the matrix cell and the reference cell. This is known as reading with "unbalanced loads".

However, as will become more evident from the following disclosure, for extreme values of parameters such as various tolerances in the manufacturing process or of the supply voltage (particularly for an unusually high supply voltage), the current $I_p$ in the programmed cell may depart from zero to such an extent that the comparison fails, and a programmed cell will be misread as virgin, or vice versa. This situation effectively limits the maximum range of acceptable supply voltages, or, from another point of view, compels the manufacturer to discard devices which would otherwise be satisfactory, because they fail at high supply voltages.

A semiconductor memory comprising a plurality of selectable matrix cells for storing data, a plurality of selectable virgin reference cells, and a sense amplifier for recognizing the status of the matrix cells is known from EP-A-0 347 935. The known semiconductor memory further includes unbalanced loads connected between a respective input of the sense amplifier and a voltage supply line, and a compensatory cell interposed between one input of the sense amplifier and the ground, said compensatory cell being in an ON-programmed state (i.e, conducting when a bias voltage is applied to its gate).

The main object of the invention is therefore to provide a semiconductor memory with an improved sense circuit, of the type with unbalanced loads, for recognizing the virgin or programmed status of the cells in storage devices which compensates the above drift of $I_p$ from zero, and extends the operating range of the sense circuit, particularly in that it allows operation with higher supply voltages.

Another object is to increase the yield of such sense devices in the manufacturing process.

The invention achieves the above and other objects and advantages, such as will appear from the following disclosure, with a semiconductor memory as defined in claim 1.

The invention will now be described in more detail with reference to a preferred embodiment, given by way of illustrative and nonlimiting example, and with the aid of the attached drawings, wherein:

Fig. 1 is a diagram of a semiconductor memory circuit with an unbalanced-load sense circuit according to the prior art;

Fig. 2 is a diagram of a semiconductor memory circuit with an unbalanced-load sense circuit according to the invention; and

Fig. 3 is a current-voltage plot showing various current quantities plotted against an increasing supply voltage for the circuits of Figs. 1 and 3.

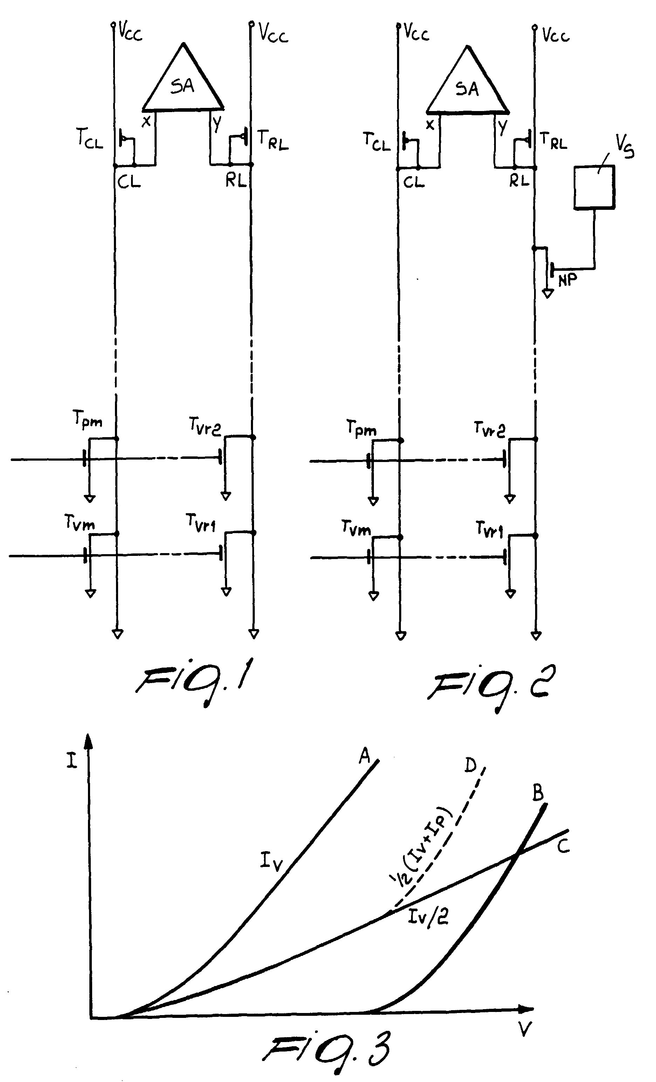

In Fig. 1, which shows a conventional sense circuit for CMOS EPROMs using the approach of "unbalanced loads", a sense differential amplifier SA has a first input X and a second input Y.

$T_{vm}$ and $T_{pm}$ are a virgin cell and a programmed cell, respectively, which are part of a matrix of cells or transistors (not shown fully) of a storage device such as a ROM, made with CMOS technology. Each of the cells $T_{vm}$ and $T_{pm}$ has a grounded source, a drain connected to a column line CL tied to a load transistor $T_{CL}$ and to input X of the sense amplifier, and a gate connected to a row line RV or RP, respectively. Each of the load transistors $T_{CL}$ can be selectively turned on, and each of the row lines can be selectively driven high by means not shown, as well known in the art, to select the cell at the crosspoint of the selected column and row. If the selected cell is virgin, such as $T_{vm}$, a current $I_{vm}$ is caused to flow through it, while, if the selected cell is programmed, such as $T_{pm}$, an ideally null current $I_{pm}$ will be caused to flow through it.

$T_{vr1}$ and $T_{vr2}$ are two virgin reference cells, corresponding to cells $T_{vm}$ and $T_{pm}$, respectively, and each of the reference cells has a grounded source, has a drain connected to a reference line RL tied to a load transistor $T_{RL}$ and to input Y of the sense amplifier, and finally has a gate connected to the row line RV or RP of the corresponding matrix cell. Transistor $T_{RL}$ can be turned on by means not shown, simultaneously with column line CL. As known in the art, there is a virgin reference cell for each row of matrix cells in the device.

As known in the art, load transistors $T_{CL}$ and $T_{RL}$ are made different, usually by making the reference load transistor $T_{RL}$ twice as large as the matrix load transistor $T_{CL}$, so that, in the ideal situation, the current through a virgin matrix cell is about half the current through the virgin reference cell. This allows the sense amplifier to give an appropriate output when reading a virgin matrix cell, as known in the art.

When the virgin matrix cell $T_{vm}$ is selected, sense amplifier SA will then compare a current $I_{vr}$ flowing in reference line RL with a current $I_{vm}/2$ flowing in column line CL. When the programmed matrix cell is selected, a current $I_{pm}/2$ will flow in column line CL. As a rule, the virgin matrix cell and the virgin reference cell are the same, i.e. $I_{vm} = I_{vr} = I_v$. And, ideally, the current in a programmed cell is zero, i.e. $I_{pm} = 0$. Then the following relations hold when reading a virgin or a programmed cell, respectively:

$$I_v > I_v/2 \qquad (1)$$

$$0 < I_v/2 \qquad (2)$$

The current value $I_v/2$ is therefore the tripping value, causing the sense amplifier to switch from an output indicating a programmed cell to an output indicating a virgin cell, or vice versa. This will be further discussed below with reference to Fig. 3.

Inequalities (1) and (2) are inherently true. However, in actual devices, and for extreme ranges in the process paramaters, in the supply voltage, in the temperature, etc., it may well happen that the current $I_{pm}$ in the programmed matrix cell is,different from 0, and the above inequalities (1) and (2) must be replaced by:

$$I_{vm} > I_v/2 \qquad (3)$$

$$I_{pm} < I_v/2 \qquad (4)$$

Whenever $I_{pm}$ departs from zero and/or $I_v$ decays from its rated value enough for $I_{pm}$ to approach half the value of $I_v$, the recognition process will break down, and a programmed cell may be read as virgin, or vice versa. This is bound to happen in particular at very high supply voltages, and effectively limits the range of acceptable operating values of the supply voltage for given tolerances in the process parameters. From another point of view, the limitation imposed by inequality (4) compels the manufacturer to reject a high number of devices which would otherwise be satisfactory.

The above situation can be better understood from the diagram of Fig. 3, where the lines show how the values of several current quantities of interest change as the supply voltage $V_{cc}$ varies from 0 V upwards. Line A shows the current $I_v$ in a virgin cell; line B shows the current $I_p$ in a programmed cell; and line C shows the current $I_v/2$, i.e. the threshold current discriminating between a decision for a virgin cell and a decision for a programmed cell in the sense amplifier. (The dashed line D will be explained later.) It can be seen that, while the current $I_p$ is substantilly zero over the greater part of the supply voltage range, it assumes non-zero values at the high end of the range. While at moderate supply voltages the threshold is halfway between $I_p$ and $I_v$, at high supply voltages, due to the smaller slope of line C, this line crosses line B, thus causing the recognition process to fail.

With reference to Fig. 2, a memory circuit with an improved sense circuit according to the invention will now be described. The sense circuit is similar to the circuit of Fig. 1, and includes all the parts shown there, which are referenced by the same reference characters also in Fig. 2. However, the circuit of Fig. 2 also comprises an compensatory programmed cell NP having a grounded source and a drain connected to input X of the sense amplifier, while its gate is driven high by a voltage source $V_s$ preferably coinciding with the supply voltage. In other words, the compensatory programmed cell NP is permanently selected.

With the sense circuit of Fig. 2, the sense amplifier will compare a current $I_v + I_p$ either with a current $I_v/2$, if a virgin matrix cell was selected, or with a current $I_p/2$, if a programmed matrix cell was selected.

In other words, the set of inequalities (3) and (4) is now replaced by the following inequalities:

$$I_{vm} > (I_{vr} + I_p)/2 \qquad (5)$$

$$I_{pm} < (I_{vr} + I_p)/2 \qquad (6)$$

where, again, the virgin matrix cell and the virgin reference cell are the same, i.e. $I_{vm} = I_{vr} = I_v$. Also, $I_{pm} = I_p$. Then, even if $I_p > 0$, the above inequalities become:

$$I_v > I_p \qquad (7)$$

$$I_p < I_v \qquad (8)$$

Since the current in a virgin cell, even in extreme situations, must always be greater than the current in a programmed cell, unless the cell has utterly broken down, inequalities (7) and (8) must always be true. Therefore the sense circuit of Fig. 2 provides for correct recognition of the status of matrix cells even at extreme ranges of the parameters, or for highly deteriorated conditions of the cells.

The new situation is reflected in the dashed line D in Fig. 3, which represents how the quantity $(I_v + I_p)/2$, i.e. the current at input X of the sense amplifier, changes with increasing supply voltage. It can be appreciated that line D stays equidistant from lines A and B over a greater range of the supply voltage.

A preferred embodiment of the invention has been disclosed above, but it is understood that changes may be made to it by the man skilled in the art within the scope of the invention. In particular, while the voltage biasing the gate of the compensatory programmed cell has been described as coinciding with the supply voltage, a value less than the supply voltage is already sufficient to achieve the objects of the invention. Moreover, although the word "programmed" used above suggests that programmation has been achieved by application of electrical biases, it should be understood also to cover programmation achieved by means of masks during the manufacturing process, e.g. in the production of ROMs.

## Claims

1. A semiconductor memory comprising:

   - a plurality of selectable matrix cells ($T_{vm}$, $T_{pm}$) for storing data, said plurality of matrix cells ($T_{vm}$, $T_{pm}$) including at least one virgin cell ($T_{vm}$) which conducts if selected and at least one programmed cell ($T_{pm}$) which substantially does not conduct if selected;
   - a plurality of selectable virgin reference cells ($T_{vr1}$, $T_{vr2}$);
   - a sense amplifier (SA) for recognizing the virgin or programmed status of said matrix cells ($T_{vm}$, $T_{pm}$) in said memory, said sense amplifier (SA) having a first input (Y) connected to a number of said selectable virgin reference cells ($T_{vr1}$, $T_{vr2}$) and a second input (X) connected to a number of said selectable matrix cells ($T_{vm}$, $T_{pm}$);
   - unbalanced loads ($T_{CL}$, $T_{RL}$) each connected between a respective said input (X, Y) of said sense amplifier (SA) and a voltage supply line ($V_{cc}$); and
   - a compensatory cell (NP), said compensatory cell (NP) being connected with its source to ground, with its drain to the first input (Y) of the sense amplifier (SA), and with its gate to a voltage source ($V_S$) which is high at least while the sense amplifier reads a selected matrix cell,

   CHARACTERIZED IN THAT said compensatory cell (NP) is a programmed cell which substantially does not conduct when selected by said voltage source ($V_S$).

2. The sense circuit of claim 1, characterized in that said voltage source ($V_s$) is permanently high.

3. The sense circuit of claim 1 or 2, characterized in that the high value of said voltage source ($V_s$) is the value of the supply voltage ($V_{cc}$).

## Patentansprüche

1. Halbleiterspeicher mit

   - einer Vielzahl von anwählbaren Matrixzellen (Tvm,Tpm) zum Speichern von Daten, wobei die Vielzahl von Matrixzellen (Tvm,Tpm) wenigstens eine ursprüngliche Zelle (Tvm) umfaßt, welche im Auswahlfalle leitet, und wenigstens eine programmierte Zelle (Tvr1,Tvr2), welche im wesentlichen im Auswahlfalle nicht leitet;

   - einer Vielzahl anwählbarer ursprünglicher Referenzzellen (Tvm,Tpm);

   - einem Sensorverstärker (SA) zum Erfassen des ursprünglichen oder des programmierten Status einer Matrixzelle (Tvm,Tpm) im Speicher, wobei der Sensorverstärker (SA) einen ersten Eingang (Y), verbunden mit einer Anzahl der anwählbaren ursprünglichen Referenzzellen (Tvr1,Tvr2), und einen zweiten Eingang (X), verbunden mit einer Anzahl der anwählbaren Matrixzellen (Tvm,Tpm), aufweist;

   - ungleiche Lasten (TCL,TRL), jede verbunden mit einem der jeweiligen Eingänge (X,Y) des Sensorverstärkers (SA) und einer Spannungsversorgungsleitung (Vcc),

   - einer Kompensationszelle (NP), welche mit ihrer Quelle mit Erde, mit Ihrem Drain-Anschluß mit dem ersten Eingang (Y) des Sensorverstärkers, und mit Ihrem Gate-Anschluß mit einer Spannungsquelle (VS) verbunden ist, welche wenigstens "high" ist, während der Sensorverstärker eine gewählte Matrixzelle liest, dadurch gekennzeichnet, daß die Kompensationszelle (NP) eine programmierte Zelle ist, welche im wesentlichen nicht leitet, wenn sie von der Spannungsquelle (VS) angewählt ist.

2. Halbleiterspeicher nach Anspruch 1, dadurch gekennzeichnet, daß die Spannungsquelle (VS) permanent "high" ist.

3. Halbleiterspeicher nach einen der Ansprüche 1 oder 2, dadurch gekennzeichnet, daß der "high"-Wert der Spannungsquelle (VS) der Wert der Versorgungsspannung ist (VCC).

## Revendications

1. Mémoire à semiconducteur comprenant :

   une pluralité de cellules matricielles sélection-

nables ($T_{vm}$, $T_{pm}$) pour mémoriser des données, la pluralité de cellules matricielles ($T_{vm}$, $T_{pm}$) comprenant au moins une cellule vierge ($T_{vm}$) qui conduit si elle est sélectionnée et au moins une cellule programmée ($T_{pm}$) qui ne conduit sensiblement pas si elle est sélectionnée ;

une pluralité de cellules de référence vierges sélectionnables ($T_{vr1}$, $T_{vr2}$) ;

un amplificateur de lecture (SA) pour reconnaître l'état vierge ou programmé des cellules matricielles ($T_{vm}$, $T_{pm}$) de la mémoire, l'amplificateur de lecture (SA) ayant une première entrée (Y) connectée à plusieurs des cellules de référence vierges sélectionnables ($T_{vr1}$, $T_{vr2}$) et une seconde entrée (X) connectée à plusieurs des cellules matricielles sélectionnables ($T_{vm}$, $T_{pm}$) ;

des charges inégales ($T_{CL}$, $T_{RL}$) dont chacune est connectée entre une entrée respective (X, Y) de l'amplificateur de lecture (SA) et une ligne de tension d'alimentation ($V_{CC}$) ; et

une cellule de compensation (NP), la cellule de compensation (NP) étant connectée par sa source à la masse, par son drain à la première entrée (Y) de l'amplificateur de lecture (SA) et par sa grille à une source de tension ($V_s$) qui est à niveau haut au moins quand l'amplificateur de lecture lit une cellule matricielle sélectionnée,

caractérisée en ce que la cellule de compensation (NP) est une cellule programmée qui ne conduit sensiblement pas quand elle est sélectionnée par la source de tension ($V_s$).

2. Circuit de lecture selon la revendication 1, caractérisé en ce que la source de tension ($V_s$) est en permanence à l'état haut.

3. Circuit de lecture selon la revendication 1 ou 2, caractérisé en ce que la valeur haute de la source de tension ($V_s$) est la valeur de la tension d'alimentation ($V_{CC}$).

Fig. 1

Fig. 2

Fig. 3

6